# FASCICULE DE BREVET EUROPEEN

(11) **EP 0 485 282 B1**
(45) Date de publication et mention de la délivrance du brevet: **27.01.1999**
(21) Numéro de dépôt: 91402970.7
(22) Date de dépôt: 06.11.1991
(51) Int. Cl.: H05K 9/00

(54) **Dispositif de protection d'une unité de traitement de signaux électroniques contre des perturbations électromagnétiques**
Schutzvorrichtung für eine signalverarbeitende Einheit gegen elektromagnetische Störungen
EMI protecting device for signal processing unit

(30) Priorité: 07.11.1990 FR 9013798
(43) Date de publication de la demande: 13.05.1992
(73) Titulaire: MATRA NORTEL COMMUNICATIONS, 29000 Quimper (FR)
(72) Inventeur: Lassalle, Michel, F-78000 Versailles (FR); Puzenat, Jean-Pierre, F-78280 Guyancourt (FR); Tessier, Claude, F-28200 Chateaudun (FR); Vilair, Daniel, F-78910 Orgerus (FR)
(74) Mandataire: Fruchard, Guy

(56) Documents cités:
- EP-A- 0 135 338
- EP-A- 0 419 332
- GB-A- 2 217 520
- US-A- 4 656 313

## Description

La présente invention concerne un dispositif de protection d'une unité de traitement de signaux électroniques contre des perturbations électromagnétiques.

On sait que lors du traitement des signaux électroniques, en particulier dans les stations de transmission d'un réseau de radio-communication, il est nécessaire de protéger les circuits de traitement électroniques contre les perturbations d'origine électromagnétique. En général, la protection est assurée par une enceinte conductrice assurant un blindage électromagnétique. La transmission des signaux électroniques à l'unité de traitement est assurée par un câble de transmission passant par une ouverture dans l'enceinte conductrice. Compte tenu des dimensions du câble de transmission et de la multiplicité des conducteurs constituant ce câble, il n'est généralement pas possible d'assurer une continuité du blindage au niveau de l'ouverture de passage du câble de transmission et une reprise de masse est donc assurée au niveau de chaque sous-ensemble de traitement afin de relier la masse de ces sous-ensembles à l'enceinte conductrice assurant le blindage. Une telle disposition n'est pas totalement satisfaisante car elle permet à des perturbations électromagnétiques de pénétrer à l'intérieur de l'enceinte par l'ouverture de passage du câble de transmission, cette ouverture ayant généralement une dimension ne permettant pas d'assurer le degré de protection requis contre les perturbations électromagnétiques.

Un but de l'invention est de proposer un dispositif de protection permettant une connexion simple et rapide du câble de transmission tout en évitant la pénétration de perturbations électromagnétiques à l'intérieur de l'enceinte de protection.

En vue de la réalisation de ce but, on prévoit selon l'invention un dispositif de protection contre des perturbations électromagnétiques d'une unité de traitement de signaux électroniques comportant une série de sous-ensembles de traitement, ce dispositif comprenant une enceinte conductrice assurant un blindage électromagnétique et comportant des moyens de raccordement, caractérisé en ce que les moyens de raccordement comprennent des bornes de connexion portées par une partie de paroi formant un décrochement vers l'intérieur de l'enceinte et disposées dans des ouvertures réalisées dans la paroi de l'enceinte et ayant une dimension maximale ne détruisant pas le blindage à un degré de protection requis contre les perturbations électromagnétiques, chaque borne de connexion étant disposée dans une ouverture avec des broches débouchant de part et d'autre des ouvertures et un boîtier conducteur relié à ladite partie de paroi.

Ainsi, les différentes bornes de connexion sont utilisées pour relier un nombre limité de conducteurs à l'unité de traitement et l'on assure une continuité totale du blindage en reliant l'unité de traitement aux bornes de connexion en utilisant des câbles de liaison blindés dont le blindage est relié au boîtier conducteur des bornes de connexion.

En outre, du côté externe de l'enceinte, le décrochement forme un logement dans lequel les câbles de transmission peuvent aisément être introduits, en particulier lorsque l'enceinte est plaquée contre un mur ou contre une autre enceinte.

Selon une version avantageuse de l'invention, pour une unité de traitement comportant une série de sous ensembles de traitement fixés à une paroi de l'enceinte les uns au-dessous des autres, on prévoit au moins une borne de connexion associée à chaque sous-ensemble et disposée sensiblement au niveau du sous-ensemble auquel elle est associée. Ainsi, on effectue un repérage ainsi des conducteurs du câble de transmission associés à un sous-ensemble de traitement donné, ce qui permet d'effectuer très rapidement une intervention sur ce sous-ensemble.

Selon un mode de réalisation préféré de l'invention le dispositif comporte une cheminée conductrice électriquement reliée à l'enceinte et formée partiellement par la partie de paroi portant les bornes de connexion, la cheminée ayant au moins une extrémité débouchant à l'extérieur de l'enceinte de sorte que du point de vue électromagnétique l'intérieur de la cheminée est extérieur à l'enceinte, et la cheminée comporte des trappes d'accès au niveau des bornes de connexion sur une paroi interne de l'enceinte.

Ainsi, la cheminée forme un logement pour le câble de transmission dans une zone se situant en-dehors du blindage électromagnétique de l'enceinte de sorte que le câble de transmission est maintenu en amont des bornes de connexion et l'on évite ainsi de soumettre ces bornes de connexion à des contraintes mécaniques.

D'autres caractéristiques et avantages de l'invention apparaîtront à la lecture de la description qui suit d'un exemple de réalisation non limitatif de l'invention, en liaison avec les dessins ci-joints parmi lesquels:

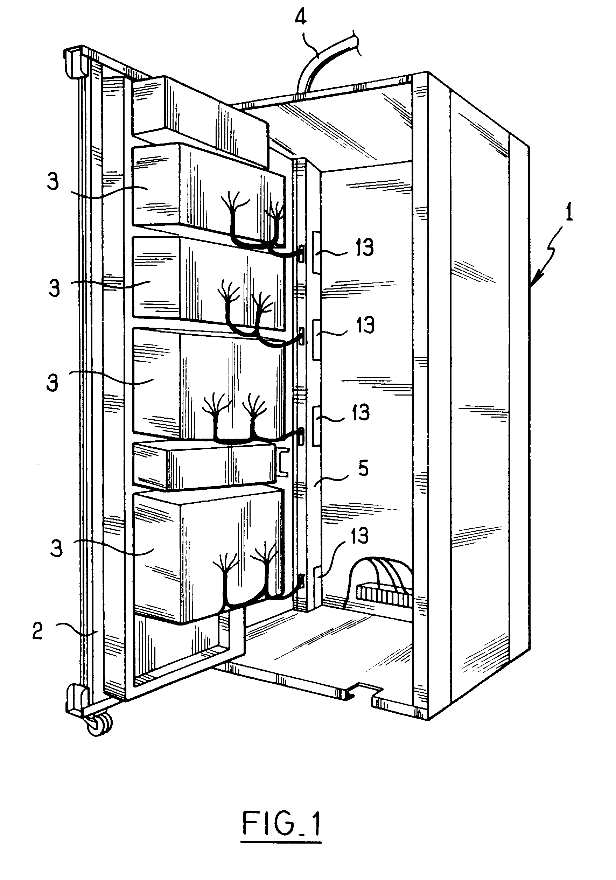

- la figure 1 est une vue en perspective schématique d'un dispositif selon l'invention,

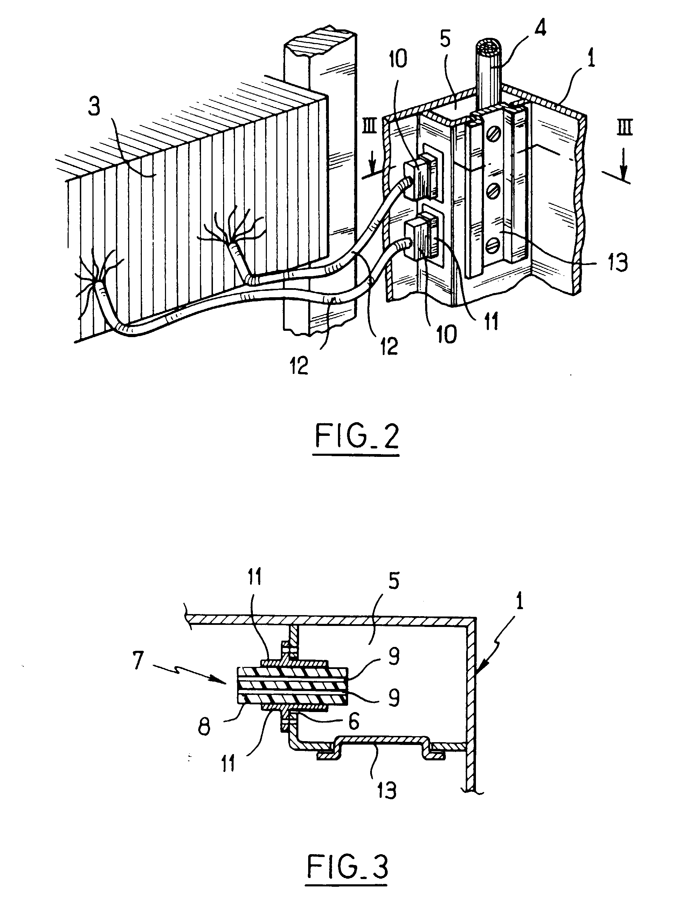

- la figure 2 est une vue en perspective d'une partie du dispositif selon l'invention,
- la figure 3 est une vue en coupe selon la ligne III-III de la figure 2.

En référence aux figures, le dispositif selon l'invention comporte une enceinte conductrice 1 de forme généralement parallélépipédique, par exemple une enceinte réalisée par soudure de tôles pleines ou ajourées sur une structure de profilé métallique.

Selon le mode de réalisation préféré illustré, l'enceinte conductrice 1 comporte un panneau pivotant 3 sur lequel sont fixés des sous-ensembles 3 d'une unité de traitement de signaux électroniques. Chaque sous-ensemble comporte une série de cartes de traitement qui doivent être reliées à un câble de transmission de signaux 4 comprenant une multiplicité de conducteurs.

Pour effectuer la liaison entre les sous-ensembles 3 et le câble de transmission 4 sans affecter le blindage réalisé par l'enceinte 1, on prévoit de préférence de réaliser selon l'invention une cheminée conductrice 5 disposée à l'intérieur de l'enceinte 1 dans un coin de celle-ci et reliée électriquement à l'enceinte 1. La cheminée 5 est par exemple réalisée en soudant un profilé en L à deux parois de l'enceinte adjacentes à un angle de celle-ci.

De préférence, la cheminée 5 est disposée de façon verticale et débouche aux extrémités supérieure et inférieure de l'enceinte 1. On remarquera que selon une section, la cheminée 5, et les ouvertures selon lesquelles elle débouche sur la face supérieure et la face inférieure de l'enceinte 1, peut avoir une dimension maximale supérieure à la dimension maximale autorisée compte tenu du degré de protection que l'on souhaite obtenir contre les perturbations électromagnétiques. En effet, du point de vue électromagnétique, l'intérieur de la cheminée 5 est en réalité extérieur à l'enceinte.

Sensiblement au niveau de chaque sous-ensemble, l'une des parois de la cheminée 5 interne à l'enceinte 1 comporte une ou plusieurs ouvertures 6, des ouvertures rectangulaires dans le mode de réalisation illustré, dont la dimension maximale, une diagonale dans l'exemple illustré, est inférieure à la dimension autorisée pour ne pas détruire le blindage formé par cette paroi de la cheminée 5 au degré de protection requis contre les perturbations électromagnétiques. Une borne de connexion généralement désignée en 7 est disposée dans chaque ouverture 6 et comporte un corps isolant 8 dans lequel sont disposées des broches conductrices 9 qui débouchent de part et d'autre des ouvertures 6. Dans l'exemple illustré, les broches 9 sont des broches femelles et le corps isolant 8 est adapté à recevoir une fiche 10 équipée de broches mâles. Les bornes de connexion 7 comportent en outre un boîtier conducteur 11 relié à la paroi de la cheminée. Dans le mode de réalisation illustré, le boîtier conducteur 11 comporte une partie tubulaire engagée dans l'ouverture 6 et une patte de fixation prenant appui sur un côté de la paroi, le boîtier étant verrouillé lors de la mise en place d'une fiche équipée de vis du côté intérieur de la cheminée. Les bornes de connexion sont reliées à un sous-ensemble 3 de niveau correspondant par des câbles de liaison 12 de faible dimension qui s'étendent sensiblement horizontalement et permettent donc une identification aisée du sous-ensemble auquel ils sont reliés. A l'intérieur de la cheminée 5 les conducteurs du câble de transmission 4 sont subdivisés en groupes reliés à une fiche (non représentée) identique à la fiche 10 et branchés sur la partie du corps 8 en saillie à l'intérieur de la cheminée 5. A ce propos, la cheminée 5 comporte de préférence des trappes d'accès 13 au niveau des bornes de connexion sur une paroi de la cheminée 5 interne à l'enceinte. Ces trappes d'accès 13 sont bien entendu équipées d'un joint électromagnétique ou réalisent des chicanes assurant une continuité du blindage que réalise la paroi correspondante de la cheminée 5.

Bien entendu l'invention n'est pas limitée au mode de réalisation décrit et on peut y apporter des variantes de réalisation sans sortir du cadre de l'invention. En particulier, bien que l'invention ait été décrite en liaison avec un mode de réalisation comportant une cheminée verticale associée à des sous-ensembles de traitement disposés les uns en dessous des autres, la disposition des broches de connexion sera bien entendu adaptée à l'agencement interne des sous-ensembles dans l'enceinte.

De même, bien que la cheminée décrite soit fermée du côté extérieur par la paroi de l'enceinte elle-même, on peut prévoir de réaliser simplement un décrochement de la paroi de l'enceinte afin de permettre une mise en place des fiches de connexion du câble de transmission 4 par l'extérieur de l'enceinte.

Les fiches de connexion peuvent avoir toute forme appropriée aux normes en vigueur. Elles peuvent également être montées sur une plaque amovible analogue à la plaque 13. Une telle disposition facilite le raccordement des câbles dans la cheminée.

Bien que l'invention ait été décrite pour une liaison du câble de transmission de signaux aux sous-ensembles, elle pourrait également s'appliquer à tout câble équivalent, par exemple un câble d'alimentation en énergie de l'armoire électrique.

## Revendications

1. Dispositif de protection contre des/électromagnétiques d'une unité de traitement de signaux électroniques comportant une série de sous-ensembles de traitement (3), ce dispositif comprenant une enceinte conductrice (1) assurant un blindage électromagnétique et comportant des moyens de raccordement, caractérisé en ce que les moyens de raccordement comprennent des bornes de connexion (7) portées par une partie de paroi formant un décrochement vers l'intérieur de l'enceinte et disposées dans des ouvertures (6) réalisées dans la paroi de l'enceinte et ayant une dimension maximale ne détruisant pas le blindage à un degré de protection requis contre les perturbations électromagnétiques, chaque borne de connexion (7) étant disposée dans une ouverture (6) avec des broches (9) débouchant de part et d'autre des ouvertures et un boîtier conducteur (11) relié à ladite partie de paroi.

2. Dispositif de protection selon la revendication 1, caractérisé en ce que chaque borne de connexion (7) associée à chaque sous-ensemble est disposée sensiblement au niveau du sous-ensemble auquel elle est associée.

3. Dispositif de protection selon l'une des revendications 1 ou 2, caractérisé en ce qu'il comporte une cheminée conductrice (1) électriquement reliée à l'enceinte et formée partiellement par la partie de paroi comportant des bornes de connexion, la cheminée ayant au moins une extrémité débouchant à l'extérieur de l'enceinte de sorte que du point de vue électromagnétique l'intérieur de la cheminée est extérieur à l'enceinte, et en ce que la cheminée comporte des trappes d'accès (13) au niveau des bornes de connexion (7) sur une paroi interne à l'enceinte.

4. Dispositif de protection selon la revendication 3, caractérisé en ce que la cheminée (5) est verticale et débouche aux extrémités supérieure et inférieure de l'enceinte.

## Patentansprüche

1. Vorrichtung zum Schutz einer eine Reihe von Verarbeitungsuntergruppen (3) umfassenden Einheit zur Verarbeitung elektronischer Signale gegen elektromagnetische Einflüsse, wobei die Vorrichtung ein leitendes Schutzgehäuse (1) hat, das eine elektromagnetische Abschirmung gewährleistet und Anschlußmittel hat, dadurch **gekennzeichnet**, daß die Anschlußmittel Verbindungsklemmen (7) enthalten, die durch einen Wandabschnitt getragen werden, der einen Rücksprung in das Innere des Schutzgehäuses bildet, und in Öffnungen (6) angeordnet sind, die in der Wand des Schutzgehäuses ausgebildet sind und eine maximale Abmessung haben, die die Abschirmung mit einem gegen elektromagnetische Störungen erforderlichen Schutzgrad nicht zerstört, wobei jede Verbindungsklemme (7) in einer Öffnung (6) mit Anschlußstiften (9) angeordnet ist, die auf beiden Seiten der Öffnungen münden, und ein leitendes Gehäuse (11) hat, das mit diesem Wandabschnitt verbunden ist.

2. Schutzvorrichtung nach Anspruch 1, dadurch **gekennzeichnet,** daß jede jeder Untergruppe zugeordnete Verbindungsklemme (7) im wesentlichen in Höhe der Untergruppe angeordnet ist, der sie zugeordnet ist.

3. Schutzvorrichtung nach einem der Ansprüche 1 oder 2, dadurch **gekennzeichnet**, daß sie einen elektrisch leitenden Schacht (5) hat, der mit dem Schutzgehäuse verbunden und teilweise durch den Wandabschnitt gebildet ist, der die Verbindungsklemmen trägt, wobei der Schacht mindestens ein Ende hat, das außerhalb des Schutzgehäuses mündet, so daß, elektromagnetisch gesehen, das Innere des Schachtes außerhalb des Schutzgehäuses ist, und, daß der Schacht in Höhe der Verbindungsklemmen (7) an einer innerhalb des Schutzgehäuses befindlichen Wand Zugriffsklappen (13) hat.

4. Schutzvorrichtung nach Anspruch 3, dadurch **gekennzeichnet,** daß der Schacht (5) vertikal ist und an den oberen und unteren Enden des Schutzgehäuses ausläuft.

## Claims

1. A protective device for providing protection against electromagnetic disturbances to a unit for processing electronic signals. which unit includes a series of processing subassemblies (3), the device comprising a conductive enclosure (1) providing electromagnetic screening and including connection means, the device being characterized in that the connection means comprise connection terminals (7) carried by a wall portion forming a setback into the inside of the enclosure and disposed in openings (6) formed through the wall of the enclosure and of maximum dimensions that do not destroy screening to a required degree of protection against electromagnetic disturbances, each connection terminal (7) being disposed in an opening (6) with pins (9) passing through openings, and a conductive housing (11) connected to said wall portion.

2. A protective device according to claim 1, characterized in that each connection terminal (7) associated with each subassembly is disposed substantially at the same level as the subassembly with which it is associated.

3. A protective device according to claim 1 or 2, characterized in that it includes a conductive chimney (5) electrically connected to the enclosure and formed in part by the wall portion carrying the connection terminals, the chimney having at least one end opening out to the outside of the enclosure such that from the electromagnetic point of view, the inside of the chimney is outside the enclosure, and in that the chimney includes access hatches (13) through an inside wall of the enclosure level with the connection terminals (7).

4. A protective device according to claim 3, characterized in that the chimney (5) is vertical and opens out in the top and bottom ends of the enclosure.
